# EUROPEAN PATENT APPLICATION

(11) **EP 0 544 305 A2**
(43) Date of publication of application: **02.06.1993**
(21) Application number: 92120222.2
(22) Date of filing: 26.11.1992
(51) Int. Cl.: H01L 23/498, H01L 21/48, H01L 21/66

(54) **Method of forming a contact bump using a composite film**

(30) Priority: 28.11.1991 JP 340384/91; 10.02.1992 JP 57536/92; 14.02.1992 JP 61228/92; 11.03.1992 JP 87942/92; 19.05.1992 JP 152849/92
(71) Applicant: NITTO DENKO CORPORATION, Osaka (JP)
(72) Inventor: Ouchi, Kazuo, c/o Nitto Denko Corporation, Ibaraki-shi, Osaka (JP); Sugimoto, Masakazu, c/o Nitto Denko Corporation, Ibaraki-shi, Osaka (JP); Tanaka, Munekazu, c/o Nitto Denko Corporation, Ibaraki-shi, Osaka (JP); Amino, Ichiro, c/o Nitto Denko Corporation, Ibaraki-shi, Osaka (JP); Morita, Syoji, c/o Nitto Denko Corporation, Ibaraki-shi, Osaka (JP)
(74) Representative: Grünecker, Kinkeldey, Stockmair & Schwanhäusser Anwaltssozietät

(57) **Abstract**

Composite film, method of forming transferred bump using the film, probe card structure obtained using the film, and process for peoducing the probe card structure using the film and the transferred bump-forming method are disclosed. The composite film comprises an insulating film (1) and a metallic material (2) extending from the front to the back side of the insulating film through a through-hole formed in the insulating film, said metallic material projecting from the insulating film on at least one side thereof and being releasable from the insulating film.

## Description

### FIELD OF THE INVENTION

The present invention relates to a composite film which enables easy formation of a bump for use in an electrical connection or as a junction point in semiconductor elements, electric parts, electric circuits, and the like, a method of forming a transferred bump using the film, a probe card structure obtained using the film, and a process for producing the probe card structure using the film and the transferred bump-forming method.

### BACKGROUND OF THE INVENTION

With the recent growth of the semiconductor industry, thickness reduction and size and weight reduction in electronic machines and instruments have been proceeding and, in the production of machines and instruments employing a large number of semiconductor devices, there is a desire to mount semiconductor elements on a certain area of a substrate at a high density. According to the present-day technique for semiconductor mounting, metallic bumps are formed on a semiconductor element directly or by transfer and this semiconductor element is mounted using the bumps as connecting terminals. If a method of forming such bumps can be applied to various kinds of electrical and electronic parts other than semiconductor elements, this leads to an improvement in mounting density in electronic machines and instruments.

Actually however, direct formation of a bump on semiconductor elements and on many kinds of other electrical and electronic parts, in general, is technically difficult and may result in a decrease in yield. On the other hand, a method of forming a bump by transfer, or a method of forming a transferred bump, has been proposed. However, the currently employed transfer method in which a bump is formed on an ITO (indium tin oxide) electrode-possessing glass has various limitations on production cost, production process, bump transfer method, etc., and is hence unsatisfactory from the standpoint of practical use thereof.

In particular, in the field of various functional parts employed in OA machines and instruments, improvements of size-reduction techniques including surface mounting are being hastened. As a result, the demand for higher mounting densities is becoming severe and mounting with a terminal pitch of 0.3 mm or less has come to be desired.

However, such high mounting densities have been difficult to attain by the ordinary technique in which bumps formed from a solder paste by printing or the like are used as connecting terminals for mounting, because according to this technique, smaller terminal pitches result in a higher possibility of formation of a solder bridge between printed solder bumps and in lower reliability of electrical connection. The printing method has another drawback that the amount of solder printed fluctuates considerably, so that it is difficult to form solder bumps with high precision.

Further, in surface mounting for electric circuits, chip-fixed resistors of a rectangular or circular shape are, for example, being used. However, the attainable size reduction in such chip-fixed resistors to be subjected to surface mounting is limited and, in addition, there are problems that the mounting requires soldering by hand or in a similar way and that positioning for mounting is difficult.

With the recent trend toward thickness reduction and size and weight reduction in electronic machines and instruments, the degree of semiconductor integration and the density of semiconductor mounting are increasing. With the progress of these, the number of electrodes in a single semiconductor device is increasing and electrode pitches in semiconductor devices are also becoming smaller year by year. Moreover, there also is a desire for a technique for checking semiconductor devices for the purpose of direct mounting of bare chips on circuit substrates or for other purposes. Although needle-type mechanical probes are usually used in the inspection of semiconductor devices, such mechanical probes, especially high-density mechanical probes, have service lives as short as from 10,000 to 20,000 times in terms of number of contacts and they also have a drawback that the relative position of needles and blades interposed between the needles readily shifts and the needles and blades often bend or, in some cases, cause a short-circuit. In addition, there are cases that since to connect a mechanical probe with a semiconductor device necessitates a force which presses the probe against the semiconductor device, needles and blades of the probe stick into the die pad of the semiconductor device to damage it and the inspection thus yields defective products. The mechanical probes moreover have a drawback that it is difficult to employ a complicated structure because impedance matching by means of needles is difficult.

As an expedient for overcoming these problems, a semiconductor-checking device obtained by forming minute holes in a base plate and filling the minute holes with an electrically conductive material to form electrically conductive paths has, for example, been proposed (JP-A-3-293566). (The term "JP-A" as used herein means an "unexamined published Japanese patent application".) Such semiconductor-checking devices, however, have restrictions on the material and thickness of the base plate because of the construction thereof. Illustratively stated, there are cases that a plate to be used as the base plate is made of a material unsuitable for selective etching for forming minute holes or has a thickness which is so large that formation of minute holes in the plate is virtually impossible. Therefore, in order to produce a semiconductor-checking device having a desired structure, the thickness of the base plate is limited considerably and, as a result, the mechanical strength of the thus-obtained semiconductor-checking device itself is also limited. Even if the checking device can be produced without any limitation on the base plate, the production process is not easy.

### SUMMARY OF THE INVENTION

The present inventors have conducted intensive studies to overcome the above-described problems. As a result, it has been found that a transferred bump can be formed easily when an insulating film of a specific structure in which a metallic material for forming a bump is held in a releasable state is used. The present invention has been completed based on this finding.

An object of the present invention is to provide a composite film which can be used for establishing an electrical connection or forming a junction point, with ease and high precision, in semiconductor elements, electrical and electronic parts, electric circuits, and the like.

Another object of the present invention is to provide a transferred bump-forming method using the above-described film.

Still another object of the present invention is to provide a probe card structure obtained using the above-described film.

A further object of the present invention is to provide a process for producing the probe card structure using the above-described film and the transferred bump-forming method.

The composite film according to the present invention comprises an insulating film and a metallic material extending from the front to the back side of the insulating film through a through-hole formed in the insulating film, the metallic material projecting from the insulating film on at least one side thereof and being releasable from the insulating film.

The method of forming a transferred bump according to the present invention comprises bringing the composite film described above into contact with a semiconductor element, an electric circuit, or an electric circuit part as an adherend and then peeling the insulating film only, with the metallic material being left on the adherend at the contact site.

The probe card structure according to the present invention comprises an insulating film, a predetermined check circuit pattern formed on the insulating film, an electrode lead formed on the insulating film, and a bump-shape metallic material bonded to the electrode lead surface.

The process for fabricating a probe card structure according to the present invention comprises the steps of forming a predetermined check circuit pattern and an electrode lead on a surface of a probe card substrate, forming a layer of a heat-fusible bonding agent on the surface of the electrode lead, preparing the composite film described above, placing the composite film on the electrode lead so that the metallic material of the composite film comes to be in a predetermined position in the surface of the electrode lead, heating the heat-fusible bonding agent on the electrode lead thereby to fix the composite film on the electrode lead surface, and peeling only the insulating film of the composite film thereby to transfer the metallic material to the electrode lead surface.

### BRIEF DESCRIPTION OF THE DRAWINGS

Fig. 1 is an enlarged sectional view of one embodiment of the composite film according to the present invention.

Fig. 2 is an enlarged sectional view of another embodiment of the composite film according to the present invention.

Fig. 3 (A) to (C) are enlarged sectional views illustrating one embodiment of the transferred bump-forming method using the composite film shown in Fig. 1 according to the present invention.

Fig. 4 (A) and (B) are enlarged sectional views illustrating another embodiment of the transferred bump-forming method using the composite film shown in Fig. 1 according to the present invention.

Fig. 5 (A) to (D) are enlarged sectional views illustrating steps of a process for producing one embodiment of the composite film according to the present invention.

Fig. 6 (A) to (D) are enlarged sectional views illustrating steps of a process for producing another embodiment of the composite film according to the present invention.

Fig. 7 is an enlarged sectional view of still another embodiment of the composite film according to the present invention.

Fig. 8 is an enlarged sectional view of a further embodiment of the composite film according to the present invention.

Fig. 9 is an enlarged sectional view of still a further embodiment of the composite film according to the present invention.

Fig. 10 is a sectional view of one embodiment of the probe card structure according to the present invention.

Fig. 11 (A) to (F) are views illustrating steps of a process for fabricating one embodiment of the probe card structure according to the present invention.

Fig. 12 is a partial sectional view of the main part of another embodiment of the probe card structure according to the present invention, the view showing another example of the metallic material.

Fig. 13 is a sectional view of still another embodiment of the probe card structure according to the present invention.

Fig. 14 is a view illustrating electrical conduction inspection of a semiconductor device using the probe card structure according to the present invention.

### DETAILED DESCRIPTION OF THE INVENTION

The composite film and the transferred bump-forming method using the film, according to the present invention, are explained below with reference to accompanying drawings.

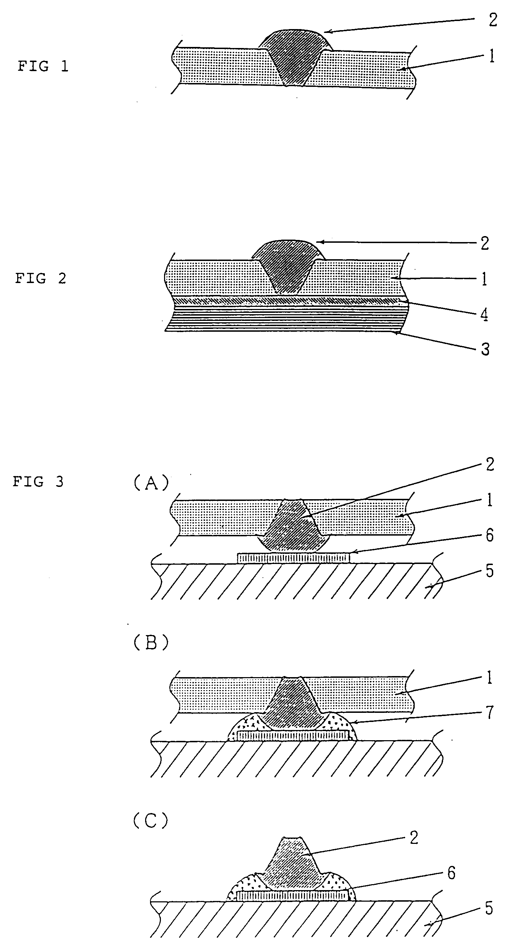

In Fig. 1 is shown an enlarged sectional view of one embodiment of the composite film according to the present invention.

As is apparent from Fig. 1, the composite film of the present invention comprises an insulating film 1 and a metallic material 2 which extends from the front to the back side of the insulating film 1 and projects from the insulating film 1 on one side thereof (upper side in the figure). The metallic material 2 in this composite film has a taper and is releasable from the insulating film 1. It is preferable that the taper of the metallic material 2 has an inclination such that the direction of the thickness of the insulating film 1 and the direction of the taper are at an angle of 20° or less, especially in the range of from 5 to 15°, to each other from the standpoint of releasability of the metallic material 2. That part of the metallic material 2 which projects from the insulating film 1 is not particularly limited in shape. However, it is preferable that in order to certainly bond and transfer the metallic material 2 to a semiconductor element, electric circuit, electric circuit part, or the like as an adherend, the projecting part has a mushroom shape as illustrated in the figure.

The metallic material 2 comprises a solder, gold, silver, copper, nickel, tin, or an alloy of any of these metals. This metallic material 2 can also be utilized, for example, as a bump resistor.

The insulating film 1 is made of a material having electrical insulating properties and appropriate heat resistance and flexibility. Examples of such a material include various thermosetting resins and thermoplastic resins, such as polyester resins, epoxy resins, urethane resins, polystyrene resins, polyethylene resins, polyamide resins, polyimide resins, ABS (acrylonitrile-butadiene-styrene) resins, polycarbonate resins, silicone resins, and fluororesins. Of these resins, transparent resins are preferred from the standpoint of easiness of positioning performed in transferred bump formation, while polyimide resins are preferred from the standpoints of heat resistance and mechanical strength.

The thickness of the insulating film 1 is arbitrarily selected according to the amount (volume) of a bump to be formed by transfer. However, from the standpoint of ensuring flexibility to the composite film, the thickness of the insulating film 1 is usually from 5 to 500 µm, preferably from 10 to 100 µm, more preferably from 15 to 40 µm.

In Fig. 2 is shown an enlarged sectional view of another preferred embodiment of the composite film according to the present invention. This composite film is provided with a pressure-sensitive sheet comprising a substrate 3 and a pressure-sensitive layer 4 on the insulating film 1 on the side of the taper head of the metallic material 2 (lower side in the figure). Due to this pressure-sensitive sheet, the metallic material 2 is prevented from falling off before use. Where the metallic material 2 is formed from a solder, it is possible to form the metallic material 2 by filling the through-hole in the insulating film 1 with a solder in a manner such that the solder comes to project from both of the front and back sides of the insulating film 1 with each projecting part being made to have a rivet head-like shape, thereby preventing the solder from falling off before use. Alternatively, solder falling may be avoided by forming a metallic layer as a supporting layer on the insulating film 1 on one side thereof. This metallic layer preferably is made of a metal which does not melt and mingle with the solder when the solder is transferred by melting and which has poor wettability by the solder, in order to transfer the solder only. Examples of such a metal include nickel and chromium. Solders usually are alloys of tin (Sn) and lead (Pb), and the component ratio of Sn/Pb varies according to the desired melting point. Exemplary ratios thereof are 90/10, 64/36, and 60/40 by weight.

In Fig. 3 are shown sectional views illustrating one embodiment of the transferred bump-forming method using the composite film shown in Fig. 1 according to the present invention.

As illustrated in Fig. 3 (A), the projecting part of the metallic material 2 in the composite film of the present invention is bonded with an electrode part 6 on an external circuit 5 as an adherend. In order to perform precise positioning in this bonding step, it is preferred to form an alignment hole or a jig hole beforehand in the composite film of this invention. Further, it is advantageous to previously form a layer of a metal 7 which readily melts upon heating, such as a solder, on the surface of the electrode part 6, because when the metallic material 2 is made of a metal, e.g., gold, having good wettability by solder, the metallic material 2 can be easily bonded with the electrode part 6, as shown in Fig. 3 (B), by only heating the metal 7 while the metallic material 2 is kept in contact with the metal 7 with or without application of pressure. After bonding, only the insulating film 1 is peeled off, whereby only the metallic material 2 can be transferred to the electrode part 6 as shown in Fig. 3 (C). Even in the case of using a semiconductor element as an adherend in place of the external circuit 5, the same procedures as described above may be conducted to form a transferred bump.

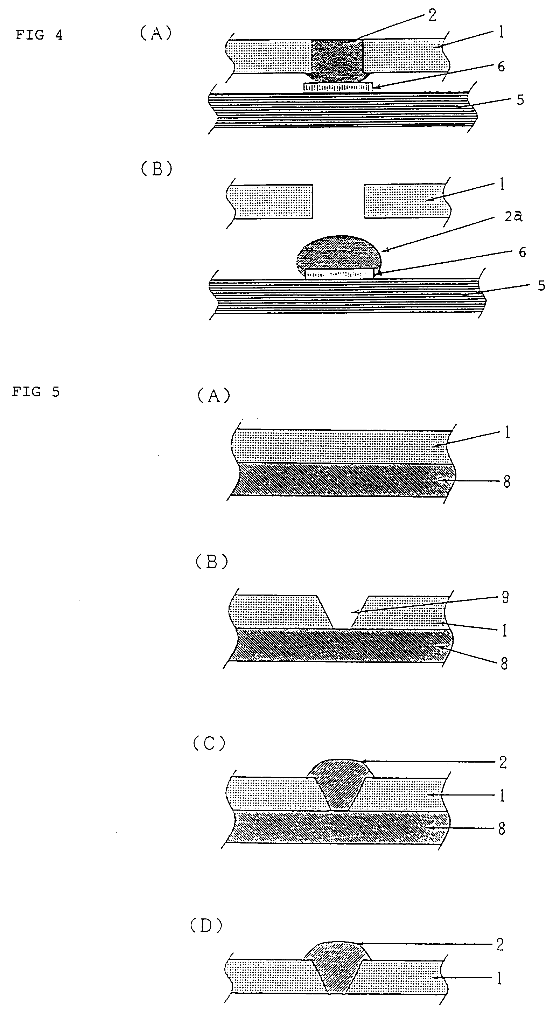

In Fig. 4 are shown sectional views illustrating one embodiment of the solder bump-forming method using the composite film (in which the metallic material is a solder) shown in Fig. 1 according to the present invention.

As shown in Fig. 4 (A), the projecting part of the solder 2 in the composite film of this invention is brought into contact with an electrode part 6 on, for example, an external circuit 5 as an adherend after or with positioning. In order to conduct this positioning precisely, it is preferred to form an alignment hole or a jig hole beforehand in the composite film of the present invention. It is also preferable that the surface of the electrode part 6 is previously covered with a metal (e.g., gold) having good wettability by the solder, because such a covering contributes to high-precision formation of a solder bump. Subsequently, the composite film of this invention is heated with a hot plate or a heating oven, upon which the solder 2 supported in the insulating film 1 melts and is transferred to the adherend (electrode part 6) to form a solder bump 2a (solder ball) of an almost spherical shape on the adherend as shown in Fig. 4 (B). Even in the case of using a semiconductor element as an adherend in place of the external circuit 5, the same procedures as described above may be conducted to form a solder bump.

In Fig. 5 are shown enlarged sectional views illustrating steps of a process for producing one embodiment of the composite film according to the present invention.

A laminate comprising a conductor layer 8 which is a copper foil, copper sheet, or the like and an insulating film 1 formed on the conductor layer 8, as shown in Fig. 5 (A), is processed to form, in the insulating film 1, a hole 9 which extends to the conductor layer 8 as shown in Fig. 5 (B). Examples of the processing method for forming the hole 9 include mechanical processing, laser processing, light processing, and chemical etching. Of these, processing with an ultraviolet laser such as an excimer laser is preferred from the standpoint that by this processing, fine holes and holes with various shapes can be formed.

Electrolytic plating is then conducted using the conductor layer 8 as an electrode, thereby to fill the hole 9 formed above with a metallic material 2 as shown in Fig. 5 (C). This plating for filling the hole 9 with the metallic material 2 is continued until the metallic material 2 being deposited comes to project from the surface of the insulating film 1. The shape and size of the projecting part of the metallic material 2 may suitably be determined according to the shape of a bump to be formed by transferring the metallic material 2 and the size of an electrode part as an adherend for the metallic material 2. However, it is preferable that from the standpoint of production precision and the like, the projecting part has a height up to about 5 times the radius of the hole, in the case that the hole has a circular cross section. Since the conductor layer 8 is removed in the subsequent step by etching, the metallic material 2 filling the hole 9 preferably is a metal which is different from the metal constituting the conductor layer 8 and has solubility different from that of the conductor layer 8.

Finally, the conductor layer 8 is removed by a known etching treatment to obtain a composite film according to the present invention as shown in Fig. 5 (D). In the composite film thus obtained, an alignment hole or a jig hole as described hereinabove may be formed by mechanical processing, laser processing, light processing, chemical etching, etc.

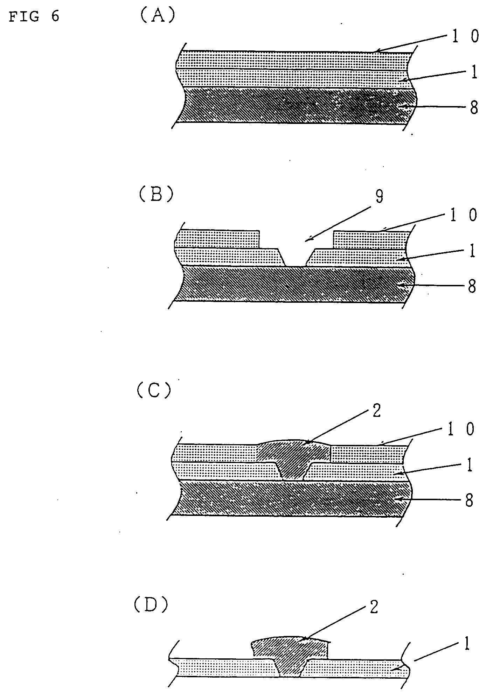

In Fig. 6 are shown enlarged sectional views illustrating steps of a process for producing another embodiment of the composite film according to the present invention.

Fig. 6 (A) shows a three-layer sheet comprising a laminate of a conductor layer 8 with an insulating film 1 and, formed on the surface of the insulating film 1, a photoresist 10. In this photoresist 10, a desired photo-pattern is formed. As shown in Fig. 6 (B), a hole 9 is then formed in the exposed part of the insulating film 1 in the same manner as in the process illustrated in Fig. 5.

Subsequently, electrolytic plating is conducted with the conductor layer 8 as an electrode to fill the hole 9 with a metallic material 2 and to allow the metallic material 2 to come to project from the insulating film 1 to form a projecting metallic material part surrounded by the photoresist 10 as shown in Fig. 6 (C). The conductor layer 8 is then removed by etching to obtain a composite film as shown in Fig. 6 (D). Due to the use of the photoresist 10 as in this process, the projecting part of the metallic material 2 can easily be designed to have an arbitrary shape.

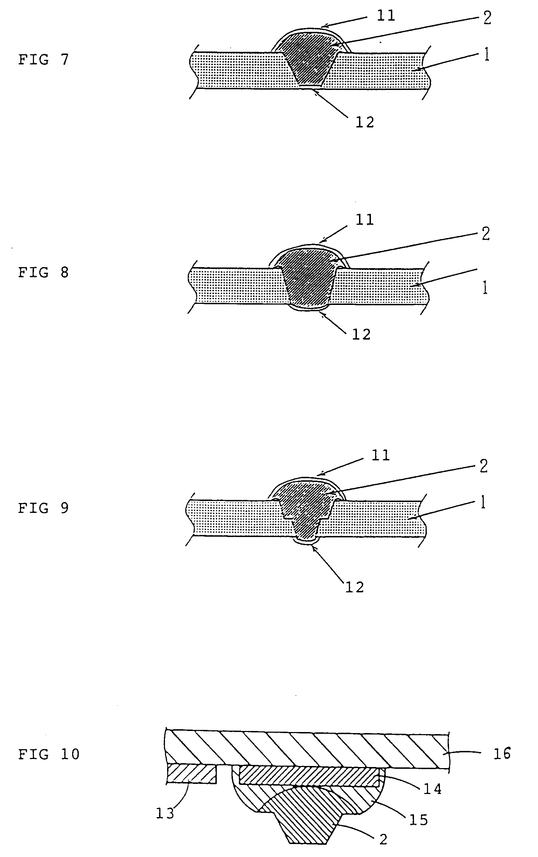

In Figs. 7 to 9 are shown sectional views of other embodiments of the composite film according to the present invention.

The composite film shown in Fig. 7 comprises an insulating film 1 and, supported therein, a metallic material 2 having a multilayer structure. This metallic material 2 has, on the surfaces thereof, metallic materials 11 and 12 having good bondability with adherends. Surface properties of the metallic material 2 can be modified by making the metallic material 2 to have such a multilayer structure. For example, where the composite film of the present invention is used for forming a transferred bump which is utilized as a junction point where a pressure is applied repeatedly or which should penetrate into an electrode part of an adherend, it is preferred to form the inner part of the metallic material 2 in Fig. 7 from a relatively hard metal such as nickel and to form the metallic materials 11 and 12, as surface layers required to have bondability with adherends, from gold or a solder.

The composite film shown in Fig. 8 has a metallic material 2 which projects from both sides of an insulating film 1. The composite film shown in Fig. 9 has a metallic material 2 in which the inner part surrounded by an insulating film 1 has discontinuously changing diameters as shown in the figure. The metallic material 2 having a projecting part which projects from the lower-side surface of the insulating film 1 as in Figs. 8 and 9 can be obtained by conducting the same procedures as in the steps illustrated in Fig. 5 (B) to (D) except that before step (C), a surface layer of the exposed part of the conductor layer 8 is removed by etching with an etchant.

The special shape of the inner part of the metallic material 2 in the composite film of Fig. 9 can be formed by conducting the same procedures as in the process illustrated in Fig. 5 except that the step of forming the hole 9 as shown in Fig. 5 (B) is performed in two stages.

As described above, by use of the composite film of the present invention, a transferred bump having an arbitrary shape according to the use of the bump can be formed. For example, the composite film of this invention can be used to form a transferred bump which penetrates into and is bonded to an electrode part of an adherend or to form a solder ball-possessing check electrode for the inspection of semiconductor elements. It is also possible to form a needle-like transferred bump by making the hole 9 to have a needle shape.

The probe card structure and the production process thereof according to the present invention are explained below with reference to accompanying drawings.

In Fig. 10 is shown a sectional view of one embodiment of the probe card structure according to the present invention. Numeral 16 denotes a probe card substrate. On one side of the probe card substrate 16, a desired check circuit pattern 13 and an electrode lead 14 are formed. To the electrode lead 14, a metallic material 2 is bonded by a heat-fusible bonding agent 15.

Examples of the material of each of the check circuit pattern 13 and the electrode lead 14 include electrically conductive materials such as various metals, e.g., gold, silver, copper, iron, nickel, and cobalt, and various alloys containing these metals as main components.

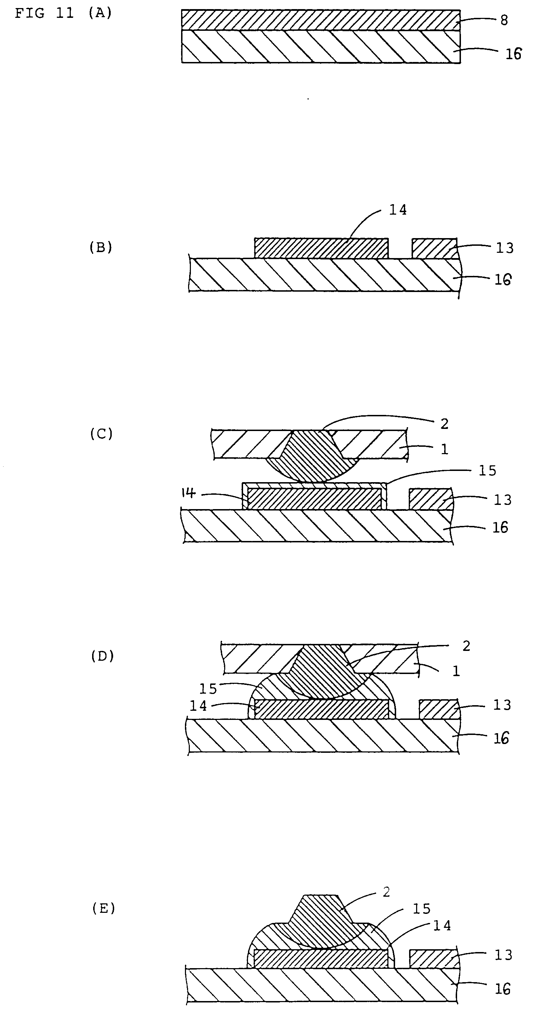

The probe card structure of the present invention is produced, for example, as follows. First, an insulating resin is coated on a conductor layer 8 such as a metal foil and then heat-cured to form a probe card substrate 16, thereby preparing a two-layer sheet. The conductor layer 8 of the two-layer sheet is then subjected to an etching treatment by a conventional method to form a desired check circuit pattern 13 and an electrode lead 14, as shown in Fig. 11 (B), in order that the probe card structure produced can be used to test semiconductor devices for predetermined functions. Subsequently, a heat-fusible bonding agent 15, such as a solder, is coated on the surface of the electrode lead 14 as shown in Fig. 11 (C). The composite film of the present invention is then placed on the coated surface of the electrode lead 14 in a manner such that the metallic material 2 in the composite film comes into contact with the electrode lead 14. Thereafter, the heat-fusible bonding agent 15 is heated with or without application of pressure to bond the metallic material 2 to the electrode lead 14 as shown in Fig. 11 (D). After the metallic material 2 is bonded, only the insulating film 1 as a support for the metallic material 2 in the composite film is peeled off as shown in Fig. 11 (E). Thus, a probe card structure of the type shown in Fig. 10 is produced.

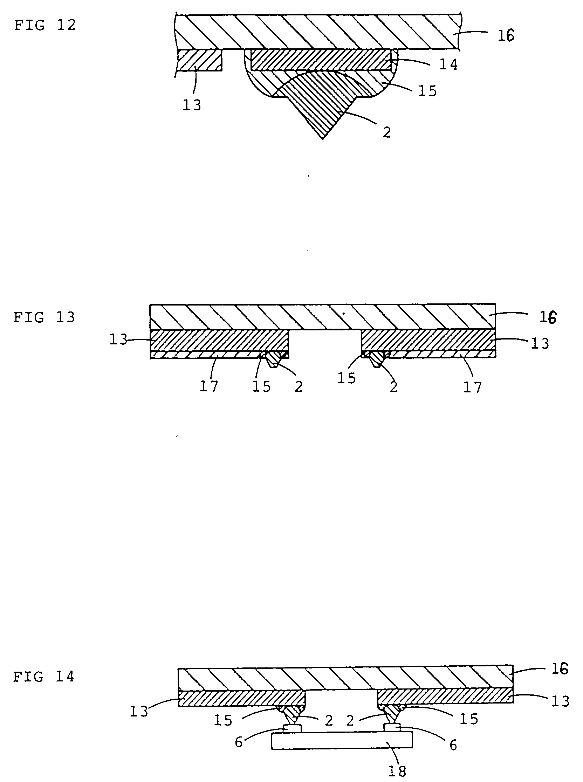

The composite film used above, which can be produced by the method described hereinabove, is not particularly limited in production method therefor and material thereof. Further, the shape of the metallic material 2 is not limited to the bump shape with a flat head as shown in Fig. 10, and the metallic material 2 may be of a shape with a pointed head like the metallic material 2a shown in Fig. 12.

Although a two-layer sheet was first prepared in the above-described process by coating an insulating resin on the conductor layer 8, it is possible to produce a two-layer sheet of the same structure by a method in which a probe card substrate 16 is previously prepared and a conductor layer 8 is formed on the insulating film 16, i.e., the probe card substrate, using an electrically conductive material by, for example, sputtering or any of various vapor deposition techniques and plating techniques.

It is preferable that, as shown in Fig. 13, protective resin layers 17 are formed on the surfaces to which the metallic materials 2 are transferred, in order that during the electrical conduction inspection of semiconductor devices using the probe card structure of the present invention, shortcircuiting is avoided, the semiconductor devices is prevented from being damaged, and the metallic materials 2 is prevented from falling off. The thickness of the protective resin layers 17 is preferably from 1 to 50 µm, more preferably from 10 to 30 µm. The material for forming the protective resin layers 17 is not particularly limited, and examples thereof include thermosetting resins such as epoxy resins and thermoplastic resins such as fluororesins.

In the probe card structure thus obtained, the metallic materials 2 which are to be brought into direct contact with a semiconductor during inspection thereof are disposed in the desired parts of the structure due to the use of the composite film. Therefore, the probe card structure can be produced so as to have a predetermined shape without any particular limitation on the material and thickness thereof, and can be used for electrical conductivity inspections without causing any problem.

An inspection of a semiconductor device using the probe card structure of the present invention may be conducted as follows. As shown in Fig. 14, metallic materials 2 of the probe card structure are brought into contact with electrode parts 6 in a semiconductor device 18 and electrical conductivity is then tested.

As described above, since a bump-forming metallic material of a desired size is releasably contained in the composite film of the present invention, a transferred bump can be formed from the metallic material with high precision and ease on an electrode part of a high-density semiconductor element or on an electrical part, electric circuit, or the like. Therefore, bump formation on semiconductor devices and other parts using the composite film of the present invention can be performed efficiently to attain a higher product yield and an improved production efficiency, as compared with the conventional bump connector technique in which a bump electrode is formed directly on a semiconductor device and this bump electrode is used as a junction point.

Furthermore, since the probe card structure of the present invention is produced by placing the composite film of this invention on an electrode lead formed on an insulating film in a manner such that the metallic bump in the composite film is placed in a predetermined position in the electrode lead surface, fixing the metallic bump to the electrode lead surface by heating, and then peeling only the base film of the composite film to transfer the metallic bump in the composite film to the electrode lead surface, the probe card structure is not limited in material and thickness thereof and can, hence, be easily made to have a desired checking ability. Therefore, when the probe card structure of the present invention is used for the inspection of semiconductors, occurrence of short-circuits between electrode leads can be avoided considerably and the semiconductor devices being inspected can be effectively prevented from suffering a damage. As a result, defective products resulting from semiconductor inspection can be diminished greatly.

While the invention has been described in detail and with reference to specific embodiments thereof, it will be apparent to one skilled in the art that various changes and modifications can be made therein without departing from the spirit and scope thereof.

## Claims

1. A composite film comprising an insulating film and a metallic material extending from the front to the back side of the insulating film through a through-hole formed in the insulating film, said metallic material projecting from the insulating film on at least one side thereof and being releasable from the insulating film.

2. A composite film as claimed in claim 1, wherein the metallic material is a solder and can be released from the insulating film by melting.

3. A composite film as claimed in claim 1, wherein the metallic material is a bump resistor.

4. A composite film as claimed in claim 1, wherein the metallic material which fills the through-hole in the insulating film has a taper.

5. A composite film as claimed in claim 4, wherein the direction of the thickness of the insulating film and the direction of the taper of the metallic material are at an angle of 20° or less.

6. A composite film as claimed in claim 1, wherein the projecting part of the metallic material is of a mushroom shape.

7. A composite film as claimed in claim 4, wherein a pressure-sensitive sheet is bonded to the insulating film surface on the taper head side of the metallic material.

8. A composite film as claimed in claim 1, wherein the through-hole through which the metallic material extends is formed by irradiation with a laser light.

9. A method of forming a transferred bump which comprises bringing the composite film as claimed in claim 1 into contact with a semiconductor element, an electric circuit, or an electric circuit part and then peeling the insulating film only, with the metallic material being left on the semiconductor element, electric circuit, or electric circuit part at the contact site.

10. A method as claimed in claim 9, which comprises bringing the composite film in which the metallic material is a solder into contact with a semiconductor element, an electric circuit, or an electric circuit part and then heating and melting the solder to transfer the solder to the contact site.

11. A method as claimed in claim 9, wherein the metallic material is a bump resistor.

12. A probe card structure which comprises an insulating film, a predetermined check circuit pattern formed on the insulating film, an electrode lead formed on the insulating film, and a bump-shape metallic material bonded to the electrode lead surface.

13. A probe card structure as claimed in claim 12, which further comprises a protective resin layer formed on the surface to which the bump-shaped metallic material is bonded.

14. A process for producing a probe card structure which comprises the steps of forming a predetermined check circuit pattern and an electrode lead on a surface of an insulating film, forming a layer of a heat-fusible bonding agent on the surface of the electrode lead, preparing the composite film as claimed in claim 1, placing the composite film on the electrode lead so that the metallic material of the composite film comes to be in a predetermined position in the surface of the electrode lead, heating the heat-fusible bonding agent on the electrode lead to fix the composite film on the electrode lead surface, and peeling only the insulating film of the composite film to transfer the metallic material to the electrode lead surface.
